# EUROPEAN PATENT SPECIFICATION

(11) **EP 1 308 986 B1**
(45) Date of publication and mention of the grant of the patent: **30.07.2008**
(21) Application number: 02023899.4
(22) Date of filing: 24.10.2002
(51) Int. Cl.: H01J 37/32

(54) **Plasma etch reactor with dual sources for enhancing both etch selectivity and etch rate**
Plasmaätzreaktor mit doppelten Quellen zur Verstärkung von Ätzselektivität und Ätzgeschwindigkeit
Réacteur de gravure par plasma à double source pour renforcer la séléctivité et la vitesse de gravure

(30) Priority: 31.10.2001 US 999581
(43) Date of publication of application: 07.05.2003
(73) Proprietor: APPLIED MATERIALS, INC., Santa Clara, California 95050 (US)
(72) Inventor: Ouye, Alan H., San Mateo, CA 94401 (US); Hagerty, John J., Livermore, CA 94550 (US); Wadensweiler, Ralph M., Sunnyvale, CA 94087 (US); Holland, John P., San Jose, CA 95126 (US); Todorov, Valentin, Fremont, CA 94538 (US); Sato, Arthur H., San Jose, CA 95129 (US); Kumar, Ajay, Sunnyvale, CA 94087 (US); Khan, Anisul, Sunnyvale, CA 94087 (US); Podlesnik, Dragan, Palo Alto, CA 94304 (US)
(74) Representative: Zimmermann, Gerd Heinrich

(56) References cited:
- EP-A- 0 685 873
- EP-A- 0 814 500
- US-A- 6 123 802

## Description

U.S. Patent No. 6,228,208 B1 discloses a magnetically enhanced reactive ion etch plasma reactor for etching a selected layer on a semiconductor wafer in the presence of an etchant-containing gas. Such a reactor is a capacitively coupled plasma reactor with a slowly circulating plasma-confining magnetic field. A capacitively coupled plasma reactor, when used in semiconductor etch processes, provides superior etch selectivity relative to an inductively coupled reactor, but the inductively coupled reactor typically provides higher ion density and therefore a higher etch rate. As a result, the inductively coupled reactor is able to etch much deeper or higher aspect ratio openings with less tendency to etch stop. On the other hand, the inferior etch selectivity of the inductively coupled reactor, arising from the greater dissociation in an inductively coupled plasma, can lead to unacceptable damage to materials other than those intended to be etched, such as photoresist layers. Therefore, in many cases an MERIE or capacitively coupled reactor is preferred.

The greater dissociation of plasma species experienced in an inductively coupled plasma arises from the greater efficiency of an inductive field in producing plasma ions. For the same amount of applied RF power, an inductively coupled field tends to produce a higher plasma ion density than a capacitively coupled field. In a plasma etch reactor, a precursor gas is introduced consisting of, for example, complex fluoro-hydrocarbon molecules which by themselves are relatively non-reactive with the material to be etched (such as silicon or silicon dioxide). The ionization of such gases in the plasma tends dissociate these molecules into simpler chemical species, at least some of which are reactive etchants for silicon or silicon dioxide. The greater the degree of dissociation, the more reactive are the resulting chemical species, until an extreme limit is reached at which the most simple etch species is produced, namely free fluorine. Free fluorine, by itself, exhibits almost no etch selectivity between silicon and photoresist, for example, but of course provides the highest etch rate. Increasing the proportion of this species in the plasma can lead to unacceptably small etch selectivity. The degree of dissociation therefore profoundly affects etch selectivity, and depends upon the amount of applied RF power. Therefore, generally in an inductively coupled reactor there is a tradeoff between etch rate, which improves with increasing levels of applied RF power, and etch selectivity, which can be diminished to an unacceptable degree when applied RF power is increased beyond moderate levels.

Generally, capacitively coupled reactors and inductively coupled reactors involve mutually exclusive reactor structures. In the capacitively coupled reactor, the ceiling must be conductive in order to provide a counter electrode for the RF power applied to the wafer support pedestal. On the other hand, in the inductively coupled reactor, RF power is applied through a coil antenna over the ceiling, so that the ceiling must be an insulator in order to be transparent to the inductive RF field.

In a capacitively coupled plasma reactor, RF plasma source power is applied across the wafer support pedestal and the conductive ceiling. The ceiling typically incorporates a gas distribution plate. Such a capacitively coupled reactor exhibits superior etch selectivity, so that photoresist layers, for example, tend to remain more intact throughout an etch process than in other types of reactors. However, the plasma density is relatively low (compared with inductively coupled reactors) so that etch rates tend to be correspondingly low. With low etch rates and/or low plasma density, such a reactor can experience etch stopping in high aspect ratio openings. One straightforward approach to solving such problems has been to simply increase the RF power applied to the wafer support pedestal so as to increase plasma density (and thereby increase the etch rate). Unfortunately, as more RF power is applied to the wafer support pedestal, the plasma can heat up to such an extent that the photoresist layer melts.

Another way of improving plasma density without increasing the applied RF power is to introduce a plasma-confining magnetic field around the volume enclosed between the ceiling and the wafer support pedestal. This is the magnetically enhanced reactive ion etch (MERIE) plasma reactor, and its MERIE field is designed to rotate so that it slowly circulates the plasma around the chamber so as to enhance plasma uniformity in addition to improving plasma density. The improvement in etch rate achieved through the introduction of an MERIE field is significant but still falls short of the etch rates that can be achieved in inductively coupled reactors. This in turn limits the usefulness of such a reactor in performing etch processes involving formation of deep trenches or deep high aspect ratio openings.

A further improvement in plasma density could be attempted by increasing the strength of the MERIE magnets to more completely confine the plasma. However, the MERIE magnetic field cannot be increased without increasing a tendency to create nonuniformities in the plasma ion distribution across the wafer surface corresponding to the pattern of the MERIE magnets. Oftentimes, such a pattern is visible on the wafer, and can lead to unacceptable process failure in the affected areas of the wafer.

Another way of improving performance of an MERIE reactor is to move the ceiling/gas distribution plate closer to the wafer support pedestal so as to reduce the plasma volume, and thereby realize a proportionate increase in plasma density, thereby further improving the etch rate. In reactors employing robot arms for the movement of wafers in and out of the reactor chamber, the minimum ceiling-to-wafer support pedestal clearance is about one inch, so that this solution can be used to increase the plasma density only up to a certain limit.

Thus, it would seem that there is no further way to fundamentally improve the etch rate and performance of an MERIE reactor.

EP 814500 discloses a plasma reactor comprising an inductor coil wrapped around the sidewall of the process chamber and a counter electrode and in which a magnetic field generator applies a rotating magnetic field.

EP 685873 discloses an inductively coupled plasma reactor with an electrode for enhancing plasma ignition.

US 6123802 discloses a plasma reactor comprising an inductor coil overlying the ceiling of the chamber and a shield structure under the coil which prevents hole light up near the holes of a gas distribution plate.

The present invention intends to overcome some of the above problems. The object is solved by the plasma reactor according to independent claim 1 and a method according to independent claim 25.

Further advantages, features, aspects and details of the invention are evident from the dependent claims, the description and the accompanying drawings.

The present invention generally relates to plasma reactors. More specifically, the present invention also relates to high selectivity, high etch rate plasma reactors.

In particular it relates to a plasma reactor for processing a semiconductor workpiece, a dual power applicator MERIE plasma reactor and to a method using a reactor.

A plasma reactor for processing a semiconductor workpiece, said reactor includes a counter electrode adjacent the reactor chamber ceiling and facing the workpiece support pedestal, with a first RF power source connected between said workpiece support pedestal and said counter electrode. Plural MERIE magnets are spaced along said side wall for generating a slowly rotating magnetic field within said chamber and gas injection ports supply process gases into the chamber. A second RF power source is connected to an inductive coil antenna overlying the ceiling. The counter electrode is conductive but has plural current-blocking apertures therein that permit inductive coupling of RF power from said coil antenna through the counter electrode.

In one embodiment, the counter electrode is a gas distribution plate having an internal process gas supply passage coupled to said plural gas injection orifices. In accordance with one implementation, the counter electrode has a central aperture from which the plural apertures extend radially outwardly, the plural apertures defining therebetween radial spokes of said counter electrode. The counter electrode further has an annular peripheral portion with the plural apertures terminating at said solid annular portion. An internal gas manifold passage within the counter electrode extends circumferentially within said solid annular portion. Plural radial internal channels extends radially through respective radial spokes between said gas manifold passage and said plural injection orifices.

The invention is also directed to methods by which the described apparatus operates. It includes method steps for carrying out every function of the apparatus. Furthermore, the invention is also directed to apparatus for carrying out disclosed methods and including apparatus parts for performing each described method steps. These method steps may be performed by way of hardware components, a computer programmed by appropriate software, by any combination of the two or in any other manner.

The invention will be better understood by reference to the following description of embodiments of the invention taken in conjunction with the accompanying drawings, wherein
FIG. 1 is a perspective partially cut-away view of a preferred embodiment of the invention.
FIG. 2 is a cut-away side view corresponding to FIG. 1.
FIG. 3 is a perspective view of a preferred embodiment of a conductive gas distribution plate in the reactor of FIGS. 1 and 2.
FIG. 4 is an interior view from below the ceiling of the reactor of FIGS. 1 and 2.
FIG. 5 illustrates a conductive gas distribution plate in accordance with one alternative embodiment of the invention.
FIG. 6 illustrates another alternative embodiment including a dielectric insert that is a distribution plate for the apertured counter electrode.
FIG. 7 is a perspective view of the dielectric insert of FIG. 6.
FIG. 8 is a top view corresponding to FIG 7.
FIG. 9 is a perspective view corresponding to FIG. 7, in which the radial spokes of the dielectric insert are relatively long.
FIG. 10 is a cross-sectional view of a portion of the embodiment of FIG. 7 in accordance with a first implementation.
FIG. 11 is a cross-sectional view of a portion of the embodiment of FIG. 7 in accordance with a second implementation.
FIG. 12 is a top view of an apertured counter electrode including a gas distribution plate in accordance with a yet further alternative embodiment in which process gas is fed from the center of the gas distribution plate.
FIG. 13 is a cross-sectional view of a portion of the gas distribution plate of FIG. 14.
FIG. 14 is a graph depicting qualitatively the competing effects of differing apportionments of RF power between capacitive and inductive coupling on etch selectivity and etch rate in the reactor of FIG. 1.
FIG. 15 is a graph depicting the effect of central aperture diameter on plasma ion distribution in the reactor of FIG. 1.

The invention increases the plasma ion density of an MERIE plasma etch reactor without sacrificing its etch rate by coupling plasma source power into the reactor chamber through more than one RF power applicator. Specifically, plasma source power is coupled into the chamber through a first RF power applicator constituting the wafer pedestal by applying RF power across the wafer pedestal and the chamber ceiling, and through a second RF power applicator constituting an inductive coil by applying RF power to an inductive coil overlying the chamber ceiling. The invention can thus simultaneously bring power into the reactor chamber by both capacitive coupling and inductive coupling. The advantage of superior etch selectivity of the MERIE capacitively coupled plasma process and the advantage of high etch rate of the inductively coupled process are realized together in this reactor. Moreover, the degree to which the resulting process favors either of these two advantages over the other is adjustable by apportioning the relative RF power levels at the two RF power applicators.

In another application, the reactor enables the sequential use of inductive coupling and capacitive coupling respectively in successive process steps.

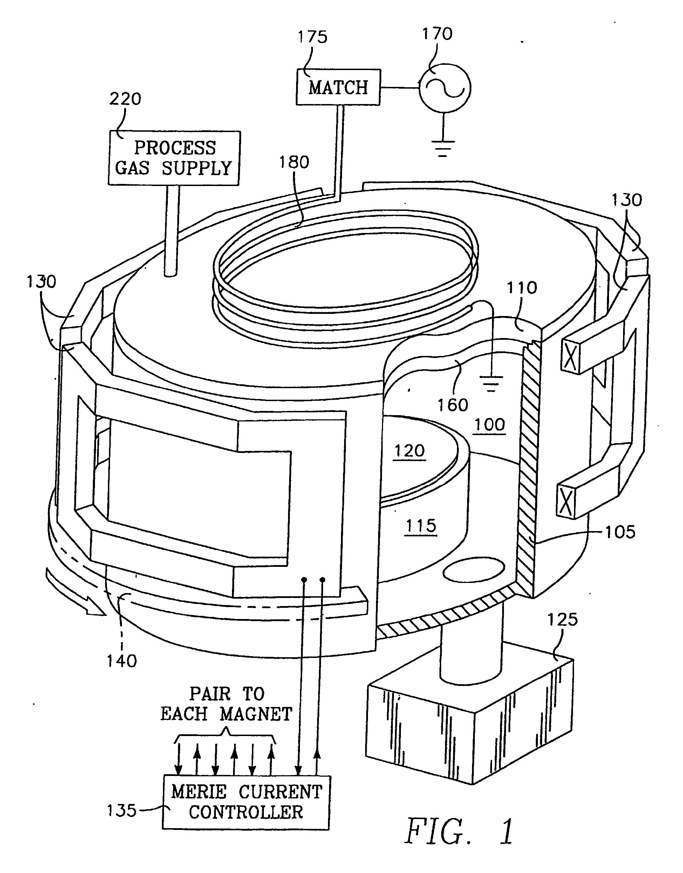

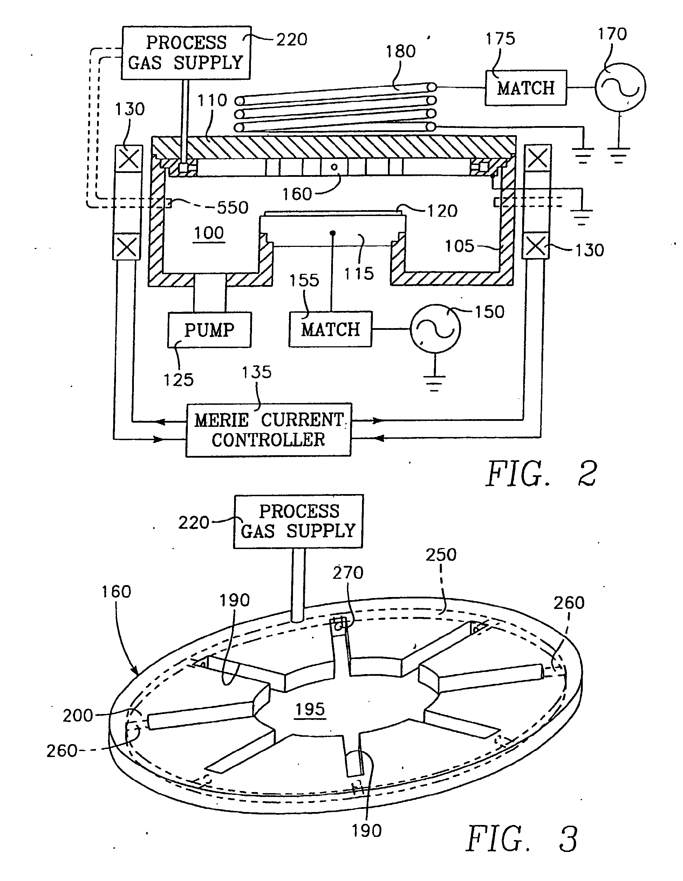

Referring to FIGS. 1 and 2, the reactor includes a vacuum chamber 100 enclosed by a cylindrical side wall 105 and a dielectric ceiling 110. A wafer support pedestal 115 lies at the bottom of the chamber 100 and supports a semiconductor wafer or workpiece 120. A vacuum pump 125 maintains a vacuum within the chamber 100. A set of MERIE magnets 130 surrounding the vacuum chamber creates a slowly rotating magnetic field across the surface of the wafer support pedestal 115. For this purpose, the MERIE magnets may be electromagnets driven with respective phases of a low frequency (e.g., 0.1-0.5 Hertz) AC current source 135. Alternatively, the MERIE magnets may be permanent magnets mounted on a slowly rotating support structure or table 140 (dashed line) rotating at, for example, 0.1-0.5 revolutions per second. Referring to FIG. 2, RF power is capacitively coupled into the chamber 100 by an RF power source 150 connected through an impedance match circuit 155 across the wafer support pedestal 115 and a conductive counter electrode 160 covered by the ceiling 110. RF power is inductively coupled into the chamber 100 by another RF power source 170 connected through an impedance match network 175 across a coil antenna 180 overlying the ceiling 110. The two RF power sources 150, 170 are operated simultaneously so that plasma RF source power is coupled into the chamber from the wafer pedestal 115 and from the coil antenna 180 simultaneously. Moreover, the two RF power sources 150, 170 are independently controllable so that the relative amount of RF power coupled through the two RF power applicators (the pedestal 115 and the coil antenna 180) may be adjusted as desired.

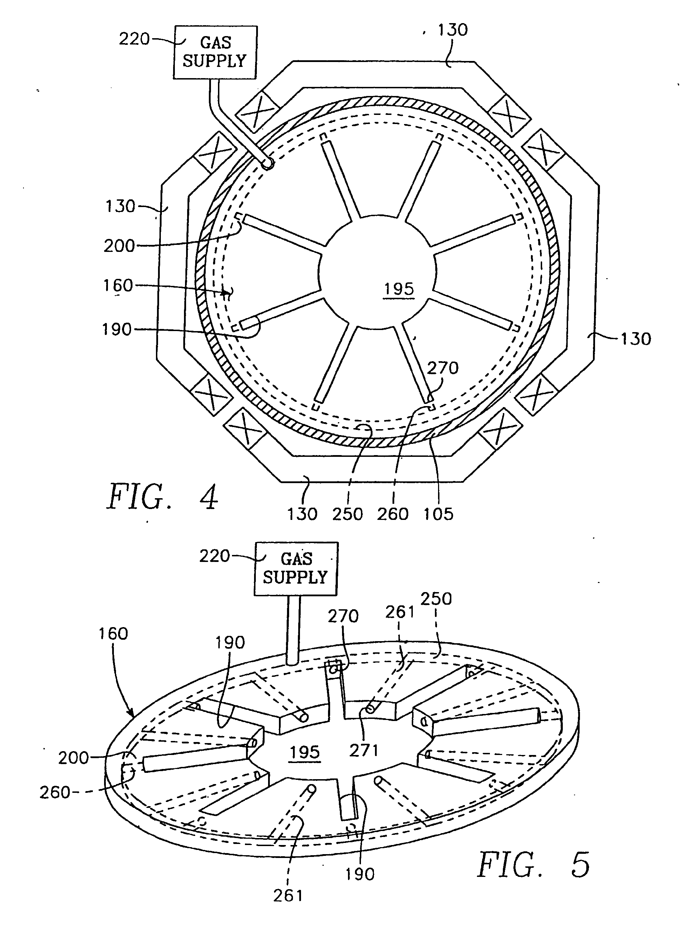

Ordinarily, it would be expected that the conductive counter electrode 160 would prevent inductive coupling from the coil antenna 180 into the chamber because the counter electrode would shield the chamber 100 from the inductive field of the coil antenna 180. In order to avoid this problem, the conductive counter electrode 160, as illustrated in FIGS. 3 and 4, has a number of radially extending apertures or voids 190 cut into it that extend radially outwardly from a central aperture 195 to an outer annulus 200 of the conductive counter electrode 160. The radially extending apertures 190 block clockwise or counterclockwise current flow around the disk-shaped counter electrode 160. Therefore, they prevent the formation of eddy currents induced by the coil antenna 180 that would otherwise absorb the power of the inductive field before it could reach the chamber 100. With the radially extending apertures 190, the counter electrode 160 is practically transparent to the inductive coil antenna 180 and yet has sufficient area to provide a fairly uniform ground plane or return potential for the RF power applied to the wafer support pedestal 115. This is because the radial apertures 190 are narrow compared to the area of the counter electrode 160. For example, the apertures may be sufficiently narrow so that each aperture occupies an area in the plane of the counter electrode that is less than 5-10% of the entire area of the counter electrode.

The inductively coupled RF field generated by the coil antenna 180 tends to dissociate plasma species into simpler and more volatile chemical species. It tends to maintain plasma density at a relatively high level, and therefore supports a rapid etch rate. However, the greater dissociation diminishes plasma etch selectivity, which can subject photoresist, for example, to damage or lifting during the plasma etch process. On the other hand, the capacitively coupled RF field between the wafer support pedestal 115 and the counter electrode 160 tends to maintain plasma density without dissociating plasma species to as great an extent, and therefore provides superior etch selectivity. The plasma density produced by the capacitively coupled field is enhanced by the MERIE magnets 130, which improves the etch rate. By applying both the inductively coupled and capacitively coupled fields simultaneously, much of the plasma is maintained by the capacitively coupled field with relatively little dissociation and therefore with good etch selectivity. The presence of the MERIE magnets 130 optimizes the etch rate. Furthermore, the etch rate is enhanced, beyond that of which the capacitively coupled field is capable, by the addition of the inductively coupled field. By apportioning RF power between the capacitive source 115, 160 and the inductive source 180 in this manner, the amount of RF power delivered by the inductive source 180 is limited so as to limit the degree of dissociation of plasma species and thereby minimize any loss in etch selectivity occasioned by the inductive source 180. Thus, an optimum balance is attained by exploiting, simultaneously, the superior etch selectivity of the MERIE capacitively coupled source and the superior etch rate of the inductively coupled source.

In the illustrated embodiment of FIGS. 1-4, the conductive counter electrode 160 is also a gas distribution plate, and the process gas is introduced through the counter electrode 160 from a process gas supply 220. This has the advantage of providing a uniform gas distribution over the top of the wafer support pedestal 115. For this purpose, the conductive counter electrode 160 has a gas distribution manifold and gas injection orifices coupled to the manifold. In accordance with a preferred embodiment, the gas distribution manifold is an annular interior channel 250 inside and concentric with the outer annulus 200 of the counter electrode 160. The gas injection orifices are radial channels 260 extending radially inwardly from the annular channel 250 and terminating into respective radial apertures 190 at corresponding gas injection holes 270. The process gas supply 220 is coupled to the gas distribution annular channel 250.

In some embodiments, the central aperture diameter is about equal to or somewhat less than the wafer diameter. Preferably, the diameter of the central aperture 195 is limited so that the counter electrode 160 presents a fairly continuous electric potential over the wafer surface. The diameter of the central aperture 195 affects the radial gas distribution in the chamber and affects the radial electric field pattern in the chamber. By increasing the diameter of the central aperture, the strength of the capacitively coupled electric field near the ceiling 110 is increased toward the chamber periphery, and vice versa.

The radial distribution of the process gas may be changed by introducing the process gas either closer or further away from the center of the ceiling. The embodiments of FIGS. 1-4, as illustrated, introduce process gas closer to the periphery of the ceiling. The alternative embodiment of FIG. 5 has the ability to introduce process gas closer to the center of the ceiling. For this purpose, radial gas distribution channels 261 extend between adjacent radial apertures 190 through the counter electrode 160 from the annular gas channel 250 to the central aperture 195 and terminate at respective gas injection openings 271. The embodiment of FIG. 5 has both (a) the gas distribution channels 270 that are aligned with the radial apertures 190 and (b) the gas distribution channels 271 that lie between adjacent radial apertures 190, while alternative embodiments may employ either one or the other.

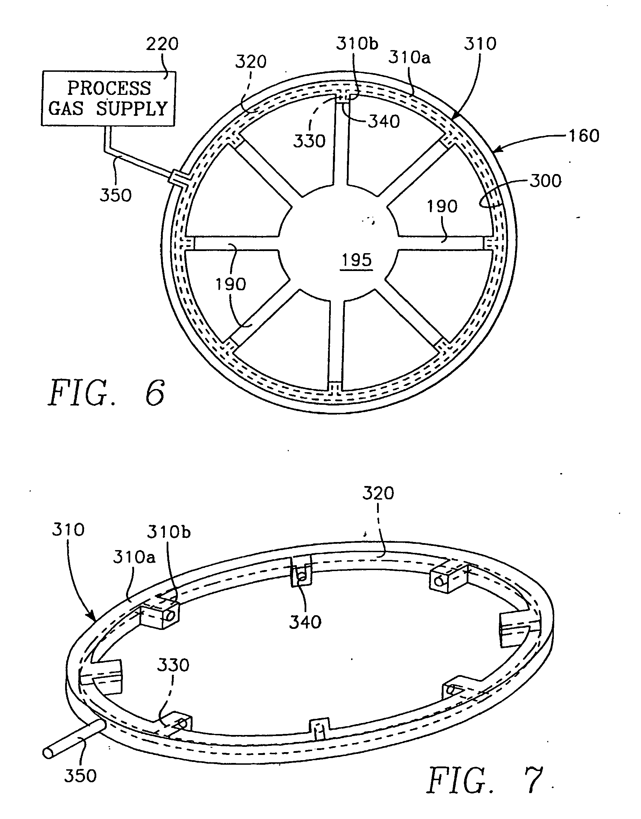

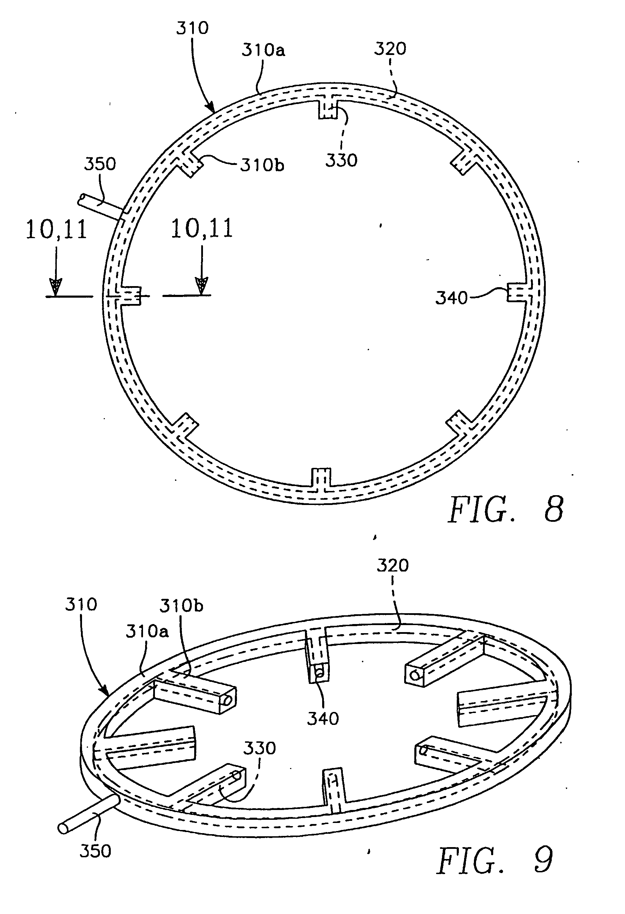

The construction of the conductive counter electrode 160 as a gas distribution plate may be realized in further alternative embodiments. For example, referring to FIG. 6, the annular interior channel 200 (of FIG. 3) may be replaced by an annular external groove 300 cut into the top surface of the counter electrode 160 that communicates with the radial apertures 190. The annular external groove 300 and the radial apertures 190 together form a wagon wheel-shaped pattern. The radial interior channels 260 are eliminated in FIG. 6 and, instead, a dielectric wagon wheel-shaped insert 310 is inserted into the wagon wheel-shaped pattern of the annular groove 300 and radial apertures 190. FIG. 7 is a perspective view of the insert 310 while FIG. 8 is a top view thereof. The dielectric insert 310 consists of a circular wheel 310a and radial hollow spokes 310b extending radially inwardly from the wheel 310a. Each spoke 310b partially extends into a respective one of the radial apertures 190. The dielectric insert 310 has a circumferential internal gas manifold channel 320 running through the interior of the wheel 310a and communicating with interior radial gas distribution channels 330 extending through respective spokes 310b. A feed line 350 connects the circumferential gas manifold channel 320 to the process gas supply 220. The radial gas distribution channels 330 terminate at respective gas injection holes 340 that open into respective radial apertures 190.

The radial distribution of the process gas may be adjusted by adjusting the radial location of the gas injection holes 340. This is accomplished by adjusting the length of the radial spokes 310b. Thus, FIG. 9 illustrates an implementation of the dielectric insert 310 in which the radial spokes 310b are longer than in the implementation of FIG. 7.

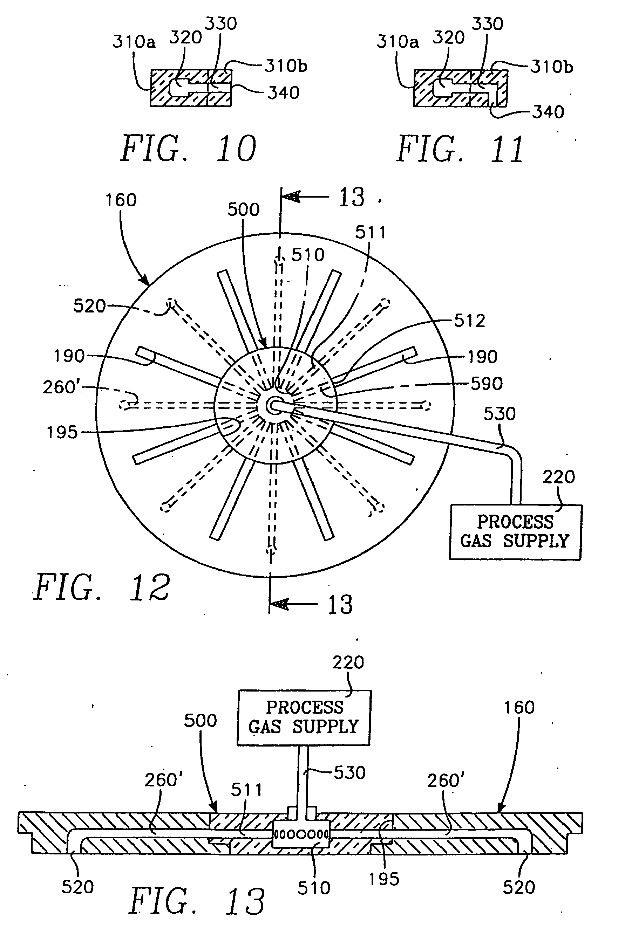

The injection holes may open horizontally into the central aperture 195 as shown in the cross-sectional view of FIG. 10 or may open downwardly toward the wafer support pedestal 115, as shown in the cross-sectional view of FIG. 11.

While process gas flow within the counter electrode 160 in the foregoing embodiments is in the radially inward direction, other implementations may be made in which gas flows in the radially outward direction within the counter electrode 160. For example, FIG. 12 illustrates an embodiment in which gas is supplied from the source 220 into the center of the counter electrode 160 and is injected into the reactor chamber 100 near the periphery of the conductive electrode 160. For this purpose, a dielectric disk 500 having about the same thickness as the counter electrode 160 is inserted into the central aperture 195. The disk 500 has an internal gas distribution manifold 510 communicating with respective internal radial passages 511 in the dielectric disk 500. Each radial passage mates with a respective one of the radial gas distribution channels 260'. In the embodiment of FIG. 12, the annular channel 250 (of FIGS. 3 and 4) is eliminated. Instead, the radial outward end of each radial gas channel 260' is terminated at a respective downwardly facing gas injection hole 520 that opens into the chamber 100. The downwardly facing gas injection hole 520 is shown in the cross-sectional view of FIG. 13. The process gas supply 220 is connected to the gas distribution manifold 510 by a gas feed line 530.

The gas injection holes 520 are located in the illustrated implementation near the periphery of the counter electrode 160. In order to allow gas injection nearer the center of the counter electrode 160 (to adjust or change the radial distribution of the process gas), radial gas passages 590 may be provided that extend within the dielectric disk 500 from the central gas manifold 510 to respective radial apertures 190 in the counter electrode 160. The radial gas passages 590 terminate at the periphery 512 of the dielectric disk 500 and thus inject process gas into the chamber closer to the center of the counter electrode 160.

While the foregoing illustrated embodiments use the counter electrode as a gas distribution plate, process gas can be injected into the chamber 100 without involving the counter electrode 160. Thus, as illustrated in dashed line in FIG. 2, gas injection nozzles 550 supplied by the process gas source 220 may be'provided that extend inwardly through the side wall 105. In this case, no gas flow channels need be provided within the counter electrode 160.

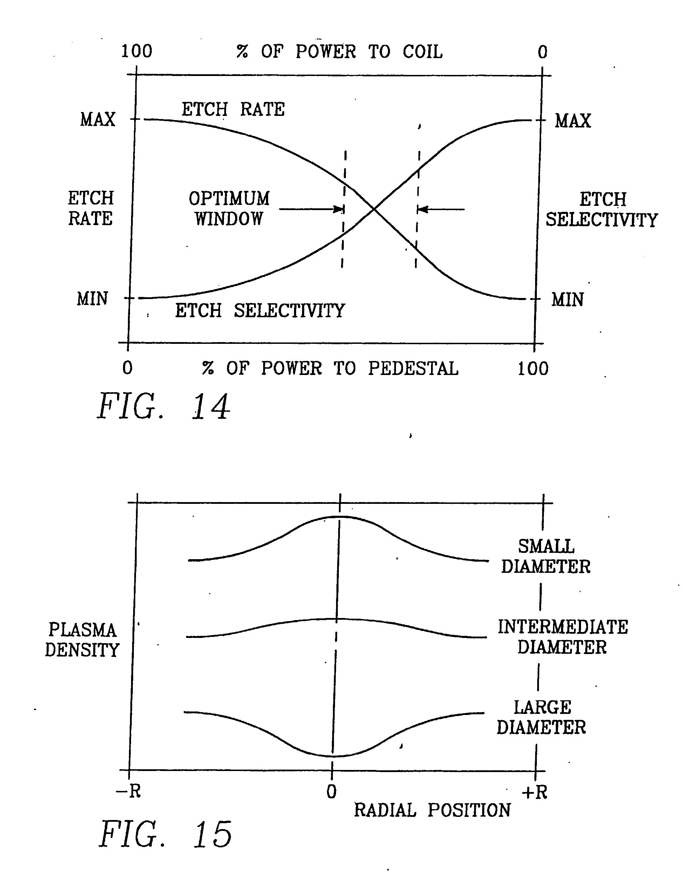

FIG. 14 is a graph depicting qualitatively the simultaneous behavior of etch rate and etch selectivity in the reactor of FIG. 1 as RF power is apportioned differently between the capacitively coupled RF power applicator 115, 160 and the inductively coupled RF power applicator 180. At the left side of the graph, all power is coupled inductively, and the etch rate is maximum while the etch selectivity is minimum. At the right side of the graph, all power is coupled capacitively and the etch selectivity is maximum while the etch rate is minimum. In an intermediate location, labelled "OPTIMUM WINDOW" in FIG. 14, each of the capacitively and inductively coupled RF power applicators contribute significantly proportions of the total applied RF power, and an optimum combination of etch rate and etch selectivity is achieved.

FIG. 15 is a graph illustrating the radial distribution of plasma ion density for different diameters of the central aperture 190 of the conductive electrode 160 of FIG. 3. The smallest diameter for the central aperture 190 yields a center high distribution near the ceiling 110 because the process gas is introduced in a region concentrated at the center, while at the same time the minimal size of the central aperture 190 produces a greater electric field near the center. The largest diameter for the central aperture yields a center low distribution near the ceiling 110 because the process gas is introduced at an annulus far away from the center, while the absence of a conductive plane across the larger central aperture 190 reduces the electric field near the center. At some intermediate diameter of the central aperture 190, therefore, there is an optimum uniformity of radial plasma ion density.

While the invention has been described in detail with reference to preferred embodiments, it is understood that variations and modifications thereof may be made.

## Claims

1. A plasma reactor for processing a semiconductor workpiece, said reactor comprising:
a vacuum enclosure (100) defining a chamber, said vacuum enclosure comprising a side wall (105) and a ceiling (110);
a workpiece support pedestal (115) within said chamber for supporting a workpiece thereon in facing relationship to said ceiling;
a counter electrode (160) adjacent said ceiling and facing said support pedestal;
a first RF power source (150) connected between said workpiece support pedestal and said counter electrode and arranged to couple plasma source power into the chamber;
plural magnets (130) spaced along said side wall arranged to generate a slowly rotating magnetic field within said chamber;
a process gas injection port; and further comprising a second RF power source (170); and
an inductive coil antenna (180) coupled to second RF power source (170) **characterised in that** said inductive coil antenna (180) overlies said ceiling, and **in that** said counter electrode comprises plural current-blocking apertures (190) therein that permit inductive coupling of RF power from said coil antenna to plasma in said chamber through said counter electrode (160).

2. The reactor of claim 1 wherein said process gas injection port comprises:
plural gas injection orifices (260, 261) in a surface of said counter electrode (160) opening into said chamber and facing said support pedestal (115).

3. The reactor of claim 2 wherein said counter electrode further comprises:
an internal process gas supply passage coupled to said plural gas injection orifices (260, 261).

4. The reactor of any of claims 2 to 3 wherein said counter electrode further comprises:
a central aperture (195) from which said plural apertures extend radially outwardly;
an annular portion adjacent a circumference of said counter electrode, said plural apertures terminating at said solid annular portion;
an internal gas manifold passage extending circumferentially within said solid annular portion;
plural radial internal channels extending radially from said gas manifold passage to said plural injection orifices (260, 261).

5. The reactor of claim 4 wherein said plural internal channels extend to and terminate at respective ones of said radial apertures, said gas injection orifices being formed at respective terminations of said plural internal channels in said radial apertures.

6. The reactor of claim 4 wherein said plural internal channels extend between adjacent ones of said radial apertures and terminate at said central aperture, said gas injection orifices being formed at respective terminations of said plural internal channels in said central aperture.

7. The reactor of any of the preceding claims wherein said magnetic field is arranged to rotate about an axis of symmetry of said chamber (100) and enhances plasma ion density over said workpiece support pedestal (115).

8. The reactor of any of claims 2 to 3 wherein said counter electrode further comprises:
a central aperture (195) from which said plural apertures extend radially outwardly;
an annular portion adjacent a circumference of said counter electrode (160), said plural apertures terminating at said solid annular portion;
a dielectric insert (310) comprising plural radial spokes (310b) lying within respective ones of said plural apertures (190), said dielectric insert comprising a process gas distribution plate and having plural gas injection orifices for distributing process gas into said chamber.

9. The reactor of claim 8 wherein said plural radial spokes (310b) have radially inward ends terminating at said central aperture, said plural gas injection orifices being located at said radially inward ends, said dielectric insert further comprising:
a wheel portion lying within said circumferential channel and a gas manifold passage extending circumferentially within said wheel portion, said plural radial spokes joining at their radially outer ends to said wheel portion;
plural radial internal channels extending through respective ones of said radial spokes between said gas manifold passage and said plural injection orifices.

10. The reactor of claim 8 wherein said plural radial spokes (310b) have radially outward ends terminating at said annular portion, said plural gas injection orifices being located at said radially outward ends, said dielectric insert (310) further comprising:
a central disk portion lying within said central aperture and a gas manifold passage within said central disk portion, said plural radial spokes joining at their radially inward ends to said central disk portion;
plural radial internal channels extending through respective ones of said radial spokes between said gas manifold passage and said plural injection orifices.

11. A plasma reactor for processing a semiconductor workpiece according to claim 1, wherein said plasma reactor is a dual power applicator magnetically enhanced reactive ion etch plasma reactor and wherein the counter electrode is covered by said ceiling (110).

12. The reactor of claim 11 wherein said process gas injection port comprises:
plural gas injection orifices in a surface of said counter electrode (160) opening into said chamber and facing said support pedestal (115).

13. The reactor of claim 12 wherein said counter electrode further comprises:
an internal process gas supply passage coupled to said plural gas injection orifices.

14. The reactor of any of claims 12 to 13 wherein said counter electrode further comprises:
a central aperture (195) from which said plural apertures extend radially outwardly;
an annular portion adjacent a circumference of said counter electrode, said plural apertures terminating at said solid annular portion;
an internal gas manifold passage extending circumferentially within said solid annular portion;
plural radial internal channels extending radially between said gas manifold passage and said plural injection orifices.

15. The reactor of any of claims 12 to 14 wherein said counter electrode further comprises:
a central aperture from which said plural apertures extend radially outwardly;
an annular portion adjacent a circumference of said counter electrode, said plural apertures terminating at said solid annular portion;
a dielectric insert (310) comprising plural radial spokes (310b) lying within respective ones of said plural apertures, said dielectric insert comprising a process gas distribution plate and having plural gas injection orifices for distributing process gas into said chamber.

16. The reactor of claim 15 wherein said plural radial spokes (310b) have radially inward ends terminating at said central aperture, said plural gas injection orifices being located at said radially inward ends, said dielectric insert (310) further comprising:
a wheel portion lying within said circumferential channel and a gas manifold passage extending circumferentially within said wheel portion, said plural radial spokes joining at their radially outer ends to said wheel portion;
plural radial internal channels extending through respective ones of said radial spokes between said gas manifold passage and said plural injection orifices.

17. The reactor of claim 15 wherein said plural radial spokes have radially outward ends terminating at said annular portion, said plural gas injection orifices being located at said radially outward ends, said dielectric insert further comprising:
a central disk portion lying within said central aperture (195) and a gas manifold passage within said central disk portion, said plural radial spokes joining at their radially inward ends to said central disk portion;
plural radial internal channels extending through respective ones of said radial spokes between said gas manifold passage and said plural injection orifices.

18. The reactor of any of claims 11 to 17 wherein said slowly rotating magnetic field of said plural magnets rotates at a frequency of between about 0.1 and 0.5 cycles per second.

19. The reactor of any of claims 11 to 18 wherein said magnetic field rotates about an axis of symmetry of said workpiece support pedestal.

20. The reactor of any of claims 11 to 19 wherein said magnetic field is arranged to enhance plasma ion density over said workpiece support pedestal.

21. The reactor of any of claims 11 to 20 wherein said ceiling (110) comprises an insulating material and said counter electrode (160) comprises conductive material and underlies said ceiling.

22. The reactor of any of claims 11 to 21 wherein said gas injection port comprises at least one gas injection nozzle adjacent said side wall.

23. The reactor of any of claims 11 to 22 wherein said plural magnets comprise electromagnets (130) spaced at equal intervals around said sidewall about an axis of symmetry of said chamber, said reactor further comprising:
a magnet current generator for furnishing respective phases of a low frequency AC current to respective ones of said electromagnets.

24. The reactor of any of claims 11 to 22 wherein said plural magnets comprise permanent magnets (130), said reactor further comprising:
a rotatable structure (140) supporting said permanent magnets.

25. A method of operating a magnetically enhanced reactive ion etch plasma reactor having a workpiece support pedestal within a vacuum chamber having a ceiling facing said pedestal, and plural magnets around said chamber for producing a rotating magnetic field within the chamber, said method comprising:
capacitively coupling RF power into said chamber by providing a counter electrode at said ceiling and applying RF power between said pedestal and counter electrode;
rendering said counter electrode transparent to inductive coupling by providing apertures within said counter electrode;
inductively coupling RF power into said chamber by providing a coil antenna over said ceiling and applying RF power to said coil antenna.

26. The method of claim 25 further comprising:
apportioning the relative levels of RF power of the capacitively coupling step and the inductively coupling step to achieve a selected etch rate and a selected etch selectivity.

## Patentansprüche

1. Plasmareaktor zum Bearbeiten eines Halbleiterwerkstücks, wobei der Plasmareaktor umfasst:
ein Vakuumgehäuse (100), das eine Kammer festlegt, wobei das Vakuumgehäuse eine Seitenwand (105) und eine Decke (110) umfasst;
einen Lagersockel (115) für das Werkstück innerhalb der Kammer, um darauf ein Werkstück der Decke zugewandt zu halten;
eine der Decke benachbarte und dem Lagersockel zugewandte Gegenelektrode (160),;
eine erste RF Energiequelle (150), die zwischen dem Werkstück und der Gegenelektrode geschalten ist und die angeordnet ist, Plasmaquellen-Energie in die Kammer zu koppeln;
mehrere Magneten (130), die entlang der Seitenwand verteilt sind, um ein langsam rotierendes Magnetfeld innerhalb der Kammer zu generieren;
eine Prozessgaseinlasszufuhr; und weiterhin eine zweite RF Energiequelle (170); und
eine induktive Spulenantenne (180), die an die zweite RF Energiequelle (170) angeschlossen ist, **dadurch gekennzeichnet, dass** die induktive Spulenantenne (180) über der Decke liegt und dass die Gegenelektrode darin mehrere Strom sperrende Aussparungen (190) umfasst, die das induktive Koppeln von RF Energie von der Spulenantenne in das Plasma in der Kammer durch die Gegenelektrode (160) ermöglicht.

2. Plasmareaktor nach Anspruch 1, wobei die Prozessgaseinlasszufuhr umfasst:
mehrere Gaseinlassöffnungen (260, 261) in einer Oberfläche der Gegenelektrode (160), die sich zu der Kammer hin öffnen und dem Lagersockel (115) zugewandt sind.

3. Reaktor nach Anspruch 2, wobei die Gegenelektrode weiterhin umfasst:
eine interne Prozessgasspeisepassage, die an die mehreren Gaseinlassöffnungen (260, 261) gekoppelt ist.

4. Plasmareaktor nach einem der Ansprüche 2 bis 3, wobei die Gegenelektrode weiterhin umfasst:
eine zentrale Aussparung (195), von der sich die mehreren Aussparungen radial nach außen hin erstrecken;
einen kreisförmigen, an einen Umfang der Gegenelektrode angrenzenden Bereich, wobei die mehreren Aussparungen an dem massiven kreisförmigen Bereich enden;
eine interne Gasverteilerpassage, die sich in Umfangsrichtung innerhalb des soliden, kreisförmigen Bereiches erstreckt;
mehrere radial, interne Kanäle, die sich radial von der Gasverteilerpassage zu den mehreren Einlassöffnungen (260, 261) erstrecken.

5. Plasmareaktor nach Anspruch 4, wobei sich die mehreren, internen Kanäle bis zu den entsprechenden der radialen Aussparungen erstrecken und an den entsprechenden der radialen Aussparungen enden, wobei die Gaseinlassöffnungen an den jeweiligen Enden der mehreren internen Kanäle in den radialen Aussparungen ausgebildet sind.

6. Plasmareaktor nach Anspruch 4, wobei sich die mehreren internen Kanäle zwischen den benachbarten Aussparungen der radialen Aussparungen erstrecken und an der zentralen Aussparung enden, wobei die Gaseinlassöffnungen an den jeweiligen Enden der mehreren internen Kanäle in der zentralen Aussparungen ausgebildet sind.

7. Plasmareaktor nach einem der vorangehenden Ansprüche, wobei das magnetische Feld angeordnet ist, um um eine Symmetrieachse der Kammer (100) zu rotieren, und die Plasmaionendichte über dem Lagersockel (115) für das Werkstück erhöht.

8. Plasmareaktor nach einem der Ansprüche 2 bis 3, wobei die Gegenelektrode weiterhin umfasst:
eine zentrale Aussparung (195), von der sich die mehreren Aussparungen radial nach außen erstrecken;
einen kreisförmigen, an einen Umfang der Gegenelektrode (160) angrenzenden Bereich, wobei die mehreren Aussparungen an dem massiven kreisförmigen Bereich enden;
einen dielektrischen Einsatz (310), der mehrere, radiale Speichen (310b) umfasst, die in den jeweiligen mehreren Aussparungen (190) liegen, wobei der dielektrische Einsatz eine Prozessgasverteilungsplatte umfasst und mehrere Gaseinlassöffnungen aufweist, um Prozessgas in die Kammer zu verteilen.

9. Plasmareaktor nach Anspruch 8, wobei die mehreren radialen Speichen (310b) radial nach innen gerichtete Enden besitzen, die an der zentralen Aussparung enden, wobei die mehreren Gaseinlassöffnungen an den radial nach innen gerichteten Enden angeordnet sind, der dielektrische Einsatz umfasst weiterhin:
einen Radbereich, der in dem umlaufenden Kanal liegt, und eine Gasverteilerpassage, die sich in Umfangsrichtung innerhalb des Radbereichs erstreckt, wobei sich die radialen Speichen an deren radial äußeren Enden mit dem Radbereich verbinden;
mehrere radiale interne Kanäle, die sich durch die jeweiligen der radialen Speichen zwischen der Gasverteilerpassage und den mehreren Einlassöffnungen erstrecken.

10. Plasmareaktor nach Anspruch 8, wobei die mehreren Speichen (310b) radial nach außen gerichtete Enden besitzen, die in dem kreisförmigen Bereich enden, wobei sich die mehreren Gaseinlassöffnungen an den radial nach außen gerichteten Enden befinden, und wobei der dielektrische Einsatz weiterhin umfasst:
einen zentralen Scheibenbereich, der in der zentralen Aussparung liegt und eine Gasverteilerpassage innerhalb des zentralen Scheibenbereichs, wobei sich die radialen Speichen an deren radial äußeren Enden mit dem genanten zentralen Scheibenbereich verbinden;
mehrere radiale interne Kanäle, die sich durch die jeweiligen der radialen Speichen zwischen der Gasverteilerpassage und den mehreren Einlassöffnungen erstrecken.

11. Plasmareaktor zum Bearbeiten eines Halbleiterwerkstücks nach Anspruch 1, wobei der Plasmareaktor ein magnetisch verstärkter Ionen-Ätz-Plasmareaktor mit dual power Anwendung ist und wobei die Gegenelektrode von der Decke (110) bedeckt wird.

12. Plasmareaktor nach Anspruch 11, wobei die Prozessgaseinlasszufuhr umfasst:
mehrere Gaseinlassöffnungen in einer Oberfläche der Gegenelektrode (160), die sich zur Kammer hin öffnen und dem Lagersockel (115) zugewandt sind.

13. Plasmareaktor nach Anspruch 12, wobei die Gegenelektrode weiterhin umfasst:
eine interne Prozessgasspeisepassage, die mit den mehreren Gaseinlassöffnungen verbunden ist.

14. Plasmareaktor nach einem der Ansprüche 12 bis 13, wobei die Gegenelektrode weiterhin umfasst:
eine zentrale Aussparung (195), von der sich die mehreren Aussparungen radial nach außen erstrecken;
einen kreisförmigen, an einen Umfang der Gegenelektrode angrenzenden Bereich, wobei die mehreren Aussparungen an dem massiven kreisförmigen Bereich enden;
eine interne Gasverteilerpassage, die sich in Umfangsrichtung innerhalb des massiven, kreisförmigen Bereiches erstreckt;
mehrere radiale, interne Kanäle, die sich radial zwischen der Gasverteilerpassage und den mehreren Einlassöffnungen erstrecken.

15. Plasmareaktor nach einem der Ansprüche 12 bis 14, wobei die Gegenelektrode weiterhin umfasst:
eine zentrale Aussparung, von der sich die mehreren Aussparungen radial nach außen erstrecken;
einen kreisförmigen, an einen Umfang der Gegenelektrode angrenzenden Bereich, wobei die mehreren Aussparungen an dem massiven kreisförmigen Bereich enden;
ein dielektrischer Einsatz (310), der mehrere, radiale Speichen (310b) umfasst, die in den jeweiligen mehreren Aussparungen (190) liegen, wobei der dielektrische Einsatz eine Prozessgasverteilungsplatte umfasst und mehrere Gaseinlassöffnungen besitzt, um Prozessgas in die Kammer zu verteilen.

16. Plasmareaktor nach Anspruch 15, wobei die mehreren radialen Speichen (310b) radial nach innen gerichtete Enden besitzen, die an der zentralen Aussparung enden, wobei die mehreren Gaseinlassöffnungen an den radial nach innen gerichteten Enden angeordnet sind, und wobei der dielektrische Einsatz weiterhin umfasst:
einen Radbereich, der in dem umlaufenden Kanal liegt, und eine Gasverteilerpassage, die sich in Umfangsrichtung innerhalb des Radbereichs erstreckt, und wobei sich die radialen Speichen an deren radial äußeren Enden mit dem Radbereich verbinden;
mehrere radiale interne Kanäle, die sich durch die jeweiligen der radialen Speichen zwischen der Gasverteilerpassage und den mehreren Einlassöffnungen erstrecken.

17. Plasmareaktor nach Anspruch 15, wobei die mehreren Speichen radial nach außen gerichtete Enden besitzen, die in dem kreisförmigen Bereich enden, wobei sich die mehreren Gaseinlassöffnungen an den radial nach außen gerichteten Enden befinden, und wobei der dielektrische Einsatz weiterhin umfasst:
einen zentralen Scheibenbereich, der in der zentralen Aussparung (195) liegt und eine Gasverteilerpassage innerhalb des zentralen Scheibenbereichs, wobei sich die mehreren radialen Speichen an deren radial inneren Enden mit dem zentralen Plattenbereich verbinden;
mehrere radiale interne Kanäle, die sich durch die jeweiligen der radialen Speichen zwischen der Gasverteilerpassage und den mehreren Einlassöffnungen erstrecken.

18. Plasmareaktor nach einem der Ansprüche 11 bis 17, wobei das langsam rotierende magnetische Feld der mehreren Magneten mit einer Frequenz von zwischen 0.1 und 0.5 Umdrehungen pro Sekunde rotiert.

19. Plasmareaktor nach einem der Ansprüche 11 bis 18, wobei das magnetische Feld um eine Symmetrieachse des Lagersockels für das Werkstück rotiert.

20. Plasmareaktor nach einem der Ansprüche 11 bis 19, wobei das magnetische Feld angeordnet ist, die Plasmaionendichte über dem Lagersockel (115) des Werkstücks zu erhöhen.

21. Plasmareaktor nach einem der Ansprüche 11 bis 20, wobei die Decke (110) ein isolierendes Material umfasst und wobei die Gegenelektrode (160) leitendes Material umfasst und unter der Decke liegt.

22. Plasmareaktor nach einem der Ansprüche 11 bis 21, wobei die Gaseinlasszufuhr mindestens eine Gaseinlassdüse neben der Seitenwand umfasst.

23. Plasmareaktor nach einem der Ansprüche 11 bis 22, wobei die mehreren Magnete Elektromagnete (130) umfassen, die in gleichen Abständen um die Seitenwand um eine Symmetrieachse der Kammer verteilt sind, wobei der Reaktor weiterhin umfasst:
einen Magnetstromgenerator, um entsprechende Phasen eines Niederfrequentwechselstroms an die entsprechenden der Elektromagnete zu liefern.

24. Plasmareaktor nach einem der Ansprüche 11 bis 22, wobei die mehreren Magneten Permanentmagneten (130) umfassen, und wobei der Reaktor weiterhin umfasst:
eine rotierbare Struktur (140), die die Permanentmagneten hält.

25. Ein Verfahren zum Verwenden eines magnetisch verstärkten reaktiven Ionen-Ätz-Plasmareaktors mit einem Lagersockel für ein Werkstück innerhalb einer Vakuumkammer mit einer Decke, die dem Sockel zugewandt ist, und mehreren Magneten um die Kammer herum, um ein rotierendes magnetisches Feld innerhalb der Kammer zu erzeugen, wobei das Verfahren umfasst:
kapazitives Koppeln von RF Energie in die Kammer durch Bereitstellen einer Gegenelektrode an der Decke und Anlegen von RF Energie zwischen dem Sockel und der Gegenelektrode;
für induktives Koppeln durchlässig machen der Gegenelektrode durch Bereitstellen von Aussparungen innerhalb der Gegenelektrode;
induktives Koppeln von RF Energie in die Kammer durch Bereitstellen einer Spulenantenne über der Decke und Anlegen von RF Energie an die Spulenantenne.

26. Verfahren nach Anspruch 25, weiterhin umfassend:
dosieren der relativen Höhe der RF Energie des kapazitiven Kopplungsschritts und des induktiven Kopplungsschritts, um eine gewählte Ätzrate und eine gewählte Ätzselektivität zu erreichen.

## Revendications

1. Réacteur à plasma pour le traitement d'une pièce d'oeuvre en semi-conducteur, ledit réacteur comprenant :
- une enceinte à vide (100) définissant une chambre, ladite enceinte à vide comprenant une paroi latérale (105) et un plafond (110) ;
un socle (115) de support pour pièce d'oeuvre au sein de ladite chambre pour supporter, sur lui, une pièce d'oeuvre tournée vers ledit plafond ;
une contre-électrode (160) adjacente audit plafond et tournée vers ledit socle de support ;
une première source d'énergie RF (150) connectée entre ledit socle de support de pièce d'oeuvre et ladite contre-électrode et agencée pour coupler la source d'énergie de plasma dans la chambre ;
des aimants multiples (130) espacés le long de ladite paroi latérale et agencés pour générer un champ magnétique tournant lentement au sein de ladite chambre ;
un orifice d'injection de gaz de traitement ;
et comprenant, en outre, une seconde source d'énergie RF (170) ; et
une bobine inductive formant antenne (180) couplée à ladite seconde source d'énergie RF (170),
**caractérisé en ce que** ladite bobine inductive formant antenne (180) recouvre ledit plafond et **en ce que** ladite contre-électrode comprend, en son sein, des ouvertures multiples (190) bloquant le courant, ouvertures qui permettent le couplage inductif de l'énergie RF depuis ladite bobine formant antenne au plasma dans la chambre via ladite contre-électrode.

2. Réacteur selon la revendication 1, dans lequel ledit orifice d'injection de gaz de traitement comprend :
des orifices d'injection de gaz multiples (260, 261) dans une surface de ladite contre-électrode (160) s'ouvrant dans ladite chambre et tournés vers ledit socle de support (115).

3. Réacteur selon la revendication 2, dans lequel ladite contre-électrode comprend en outre :
un passage interne d'alimentation en gaz de traitement couplé auxdits orifices d'injection de gaz multiples (260, 261).

4. Réacteur selon l'une quelconque des revendications 2 ou 3, dans lequel ladite contre-électrode comprend en outre :
une ouverture centrale (195) depuis laquelle lesdites ouvertures multiples s'étendent radialement vers l'extérieur ;
une portion annulaire adjacente à une circonférence de ladite contre-électrode, lesdites ouvertures multiples se terminant au niveau de ladite portion annulaire pleine ;
un passage interne répartiteur de gaz s'étendant circonférentiellement au sein de ladite portion annulaire pleine ;
des canaux internes radiaux multiples s'étendant radialement depuis ledit passage interne répartiteur de gaz vers lesdits orifices d'injection multiples (260, 261).

5. Réacteur selon la revendication 4, dans lequel lesdits canaux internes multiples s'étendent chacun vers l'une, respective, desdites ouvertures radiales et se terminent au niveau de ladite ouverture, lesdits orifices d'injection de gaz étant formés au niveau des terminaisons respectives desdits canaux internes multiples dans lesdites ouvertures radiales.

6. Réacteur selon la revendication 4, dans lequel lesdits canaux internes multiples s'étendent entre des ouvertures radiales adjacentes et se terminent au niveau de ladite ouverture centrale, lesdits orifices d'injection de gaz étant formés au niveau des terminaisons respectives desdits canaux internes multiples dans ladite ouverture centrale.

7. Réacteur selon l'une quelconque des revendications précédentes, dans lequel ledit champ magnétique est agencé pour tourner autour d'un axe de symétrie de ladite chambre (100) et augmente la densité d'ions du plasma sur ledit socle de support (115) de pièce d'oeuvre.

8. Réacteur selon l'une quelconque des revendications 2 ou 3, dans lequel ladite contre-électrode comprend en outre :
une ouverture centrale (195) depuis laquelle lesdites ouvertures multiples s'étendent radialement vers l'extérieur ;
une portion annulaire adjacente à une circonférence de ladite contre-électrode (160), lesdites ouvertures multiples se terminant au niveau de ladite portion annulaire pleine ;
un insert diélectrique (310) comprenant des rayons radiaux multiples (310b) s'étendant chacun dans l'une, respective, desdites ouvertures multiples (190), ledit insert diélectrique comprenant une plaque de distribution de gaz de traitement et ayant des orifices d'injection de gaz multiples pour distribuer du gaz de traitement dans ladite chambre.

9. Réacteur selon la revendication 8, dans lequel lesdits rayons radiaux multiples (310b) ont des extrémités radialement intérieures se terminant au niveau de ladite ouverture centrale, lesdits orifices d'injection de gaz multiples étant situés au niveau desdites extrémités radialement intérieures, ledit insert diélectrique comprenant en outre :
une portion de roue reposant au sein dudit canal circonférentiel et un passage répartiteur de gaz s'étendant circonférentiellement au sein de ladite portion de roue, lesdits rayons radiaux multiples se réunissant au niveau de leurs extrémités radialement extérieures à ladite portion de roue ;
des canaux internes radiaux multiples s'étendant chacun au travers d'un, respectif, desdits rayons radiaux entre ledit passage répartiteur de gaz et lesdits orifices d'injection multiples.

10. Réacteur selon la revendication 8, dans lequel lesdits rayons radiaux multiples (310b) ont des extrémités radialement extérieures se terminant au niveau de ladite portion annulaire, lesdits orifices d'injection de gaz multiples étant situés au niveau desdites extrémités radialement extérieures, ledit insert diélectrique (310) comprenant en outre :
une portion de disque centrale reposant au sein de ladite ouverture centrale et un passage répartiteur de gaz s'étendant au sein de ladite portion de disque centrale, lesdits rayons radiaux multiples se réunissant au niveau de leurs extrémités radialement intérieures à ladite portion de disque centrale ;
des canaux internes radiaux multiples s'étendant chacun au travers d'un, respectif, desdits rayons radiaux entre ledit passage répartiteur de gaz et lesdits orifices d'injection multiples.

11. Réacteur à plasma pour le traitement d'une pièce d'oeuvre en semi-conducteur selon la revendication 1, dans lequel ledit réacteur à plasma est un réacteur à plasma pour gravure par ions réactifs, renforcé magnétiquement et à applicateur de puissance double, et dans lequel la contre-électrode est couverte par ledit plafond (110).

12. Réacteur selon la revendication 11, dans lequel ledit orifice d'injection de gaz de traitement comprend :
des orifices d'injection de gaz multiples dans une surface de ladite contre-électrode (160) s'ouvrant dans ladite chambre et tournée vers ledit socle de support (115).

13. Réacteur selon la revendication 12, dans lequel ladite contre-électrode comprend en outre :
un passage interne d'alimentation en gaz de traitement couplé auxdits orifices d'injection de gaz multiples.

14. Réacteur selon l'une quelconque des revendications 12 ou 13, dans lequel ladite contre-électrode comprend en outre :
une ouverture centrale (195) depuis laquelle lesdites ouvertures multiples s'étendent radialement vers l'extérieur ;
une portion annulaire adjacente à une circonférence de ladite contre-électrode, lesdites ouvertures multiples se terminant au niveau de ladite portion annulaire pleine ;
un passage interne répartiteur de gaz s'étendant circonférentiellement au sein de ladite portion annulaire pleine ;
des canaux internes radiaux multiples s'étendant radialement entre ledit passage répartiteur de gaz et lesdits orifices d'injection multiples.

15. Réacteur selon l'une quelconque des revendications 12 à 14, dans lequel ladite contre-électrode comprend en outre :
une ouverture centrale depuis laquelle lesdites ouvertures multiples s'étendent radialement vers l'extérieur ;
une portion annulaire adjacente à une circonférence de ladite contre-électrode, lesdites ouvertures multiples se terminant au niveau de ladite portion annulaire pleine ;
un insert diélectrique (310) comprenant des rayons radiaux multiples (310b) s'étendant chacun dans l'une, respective, desdites ouvertures multiples, ledit insert diélectrique comprenant une plaque de distribution de gaz de traitement et ayant des orifices d'injection de gaz multiples pour distribuer du gaz de traitement dans ladite chambre.

16. Réacteur selon la revendication 15, dans lequel lesdits rayons radiaux multiples (310b) ont des extrémités radialement intérieures se terminant au niveau de ladite ouverture centrale, lesdits orifices d'injection de gaz multiples étant situés au niveau desdites extrémités radialement intérieures, ledit insert diélectrique (310) comprenant en outre :
une portion de roue reposant au sein dudit canal circonférentiel et un passage répartiteur de gaz s'étendant circonférentiellement au sein de ladite portion de roue, lesdits rayons radiaux multiples se réunissant au niveau de leurs extrémités radialement extérieures à ladite portion de roue ;
des canaux internes radiaux multiples s'étendant chacun au travers d'un, respectif, desdits rayons radiaux entre ledit passage répartiteur de gaz et lesdits orifices d'injection multiples.

17. Réacteur selon la revendication 15, dans lequel lesdits rayons radiaux multiples ont des extrémités radialement extérieures se terminant au niveau de ladite portion annulaire, lesdits orifices d'injection de gaz multiples étant situés au niveau desdites extrémités radialement extérieures, ledit insert diélectrique comprenant en outre :
une portion de disque centrale reposant au sein de ladite ouverture centrale (195) et un passage répartiteur de gaz s'étendant au sein de ladite portion de disque centrale, lesdits rayons radiaux multiples se réunissant au niveau de leurs extrémités radialement intérieures à ladite portion de disque centrale ;
des canaux internes radiaux multiples s'étendant chacun au travers d'un, respectif, desdits rayons radiaux entre ledit passage répartiteur de gaz et lesdits orifices d'injection multiples.

18. Réacteur selon l'une quelconque des revendications 11 à 17, dans lequel ledit champ magnétique tournant lentement desdits aimants multiples tourne à une fréquence comprise entre environ 0,1 et 0,5 cycle par seconde.

19. Réacteur selon l'une quelconque des revendications 11 à 18, dans lequel ledit champ magnétique tourne autour d'un axe de symétrie dudit socle de support de la pièce d'oeuvre.

20. Réacteur selon l'une quelconque des revendications 11 à 19, dans lequel ledit champ magnétique est agencé de façon- à renforcer la densité d'ions du plasma sur ledit socle de support de la pièce d'oeuvre.

21. Réacteur selon l'une quelconque des revendications 11 à 20, dans lequel ledit plafond (110) comprend un matériau isolant et ladite contre-électrode (160) comprend un matériau conducteur et est sous-jacente audit plafond

22. Réacteur selon l'une quelconque des revendications 11 à 21, dans lequel ledit orifice d'injection de gaz comprend au moins une buse d'injection de gaz adjacente à ladite paroi latérale.

23. Réacteur selon l'une quelconque des revendications 11 à 22, dans lequel lesdits aimants multiples comprennent des électroaimants (130) équidistants le long de ladite paroi latérale autour d'un axe de symétrie de ladite chambre, ledit réacteur comprenant en outre :
un générateur de courant magnétique pour fournir des phases respectives d'un courant alternatif de basse fréquence à chacun desdits électroaimants respectifs.

24. Réacteur selon l'une quelconque des revendications 11 à 22, dans lequel lesdits aimants multiples comprennent des aimants permanents (130), ledit réacteur comprenant en outre :
une structure rotative (140) supportant lesdits aimants permanents.

25. Procédé de mise en oeuvre d'un réacteur à plasma pour gravure par ions réactifs, renforcé magnétiquement, ayant un socle de support de pièce d'oeuvre au sein d'une chambre à vide ayant un plafond tourné vers ledit socle, et des aimants multiples autour de ladite chambre pour produire un champ magnétique tournant au sein de la chambre, ledit procédé comprenant :
le couplage capacitif d'énergie RF dans ladite chambre en prévoyant une contre-électrode au niveau du plafond et l'application d'énergie RF entre ledit socle et ladite contre-électrode ;
le fait de rendre ladite contre-électrode transparente au couplage inductif en prévoyant des ouvertures au sein de ladite contre-électrode ;
le couplage inductif d'énergie RF dans ladite chambre en prévoyant une bobine formant antenne sur ledit plafond et l'application d'énergie RF à ladite bobine formant antenne.

26. Procédé selon la revendication 25, comprenant en outre :
la répartition des niveaux relatifs d'énergie RF de l'étape de couplage capacitif et de l'étape de couplage inductif pour obtenir un taux de gravure sélectionné et une sélectivité de gravure sélectionnée.
